# EUROPEAN PATENT APPLICATION

(11) **EP 2 333 860 A1**
(43) Date of publication of application: **15.06.2011**
(21) Application number: 09178954.5
(22) Date of filing: 11.12.2009
(51) Int. Cl.: H01L 51/42

(54) **Organic photovoltaic cell**

(71) Applicant: Sigler, Laurent, 57330 Hettange-Grande (FR)
(72) Inventor: Sigler, Laurent, 57330 HETTANGE-GRANDE (FR)
(74) Representative: pronovem

(57) **Abstract**

The present invention relates to an organic photovoltaic cell comprising an anode a cathode (5), and a support (2), said photovoltaic cell (1) comprising a p-type material and an n-type material, said p-type material being a layer of highly crystalline polyaniline (4) deposited on at least one surface (21 or 21) of said support (2), said n-type material being a layer of low crystalline polyaniline or amorphous polyaniline (5) deposited on said layer of highly crystalline polyaniline (4).

## Description

### Field of the invention

The present invention relates to an organic photovoltaic cell comprising a polymer having semi-conductor properties, and relates to a process to produce such organic photovoltaic cell.

### Prior art and related technical background

Typically, a photovoltaic cell comprises electrodes (an anode and a cathode), and in between conducting materials, i.e. an electron donor material and an electron acceptor material. Generally semiconductor materials are used, one having an excess of electrons, named "n-type", and the other a deficit of electrons, named "p-type", the contact region being named p-n junction.

Exposure to solar radiation generates free electrons within the semiconductor materials. The positions left free by the electrons act as positive charges and take the name of "holes". When the photons create free electrons and holes in proximity to the p-n junction, the internal electric field, produced by the p-n junction, makes them move in opposite directions: the electrons move towards the side "n" and the holes move towards the side "p", resulting in the buildup of a voltage between two electrodes.

Conventionally, a photovoltaic cell comprises an inorganic semiconductor, typically a single crystalline silicon as n-type and p-type material, either in a amorphous form or crystalline form.

For example, US4388482 discloses an amorphous silicon type photovoltaic cell.

However, the inorganic photovoltaic cells have the drawback of being expensive and of using a complex and demanding manufacturing process.

During recent years, organic semiconductors were developed as an alternative to inorganic semiconductor (i.e silicon), using synthetic polymers having semi-conductor properties.

Conductive polymers are well known. There are generally conjugated polymers as for example polythiophene, polypyrrole, PEDOT/PSS and polyaniline (PANI). In particular polyaniline is known to be easily synthesized and to present high electrical conductivity. For example, W02009/115714 disclose a process to synthesise polyaniline with 80% of crystalline phase.

Typically, in an organic photovoltaic cell, conjugated polymers are used as p-type material, and generally such polymers are in the as-synthesized form. Such semiconducting polymers can also be n-type doped (by addition of electrons into the high energy p* electronic energy levels), however the resulting n-type materials are often environmentally unstable. Thus the synthesis of conjugated polymers within a dedicated range of ionization potential and electronic affinity represents an issue for the creation and the development of photovoltaic active materials.

US5331183 disclosed organic photovoltaic cells comprising a layer of a conjugated polymer as electron donor, and a layer of an acceptor material, being fullerenes, substituted fullerenes, fullerene derivatives, polymers comprising fullerenes or substituted fullerenes.

However, semiconducting polymers used as electron donors in photovoltaic cells have a low environmental stability due to their low oxidation potential. Therefore, the photoactive material has to be protected, always on the cathode side, and sometimes on the anode side. Generally, this is achieved by using a transparent protective layer, generally ITO also used as the anode, or by using a flexible gas barrier material on the cathode side, which thus increase the overall production cost of a photovoltaic cell.

One of the main key limitations to produce organic photovoltaic cells, comprising semiconducting polymers, is the difficulty in preparing multi-layer materials.

Among the different possible processes, such as spin coating, roll coating or doctor blading, inkjet-type printing was presented as a preferred technique for polymer semiconductors. However, it is still a major challenge to obtain 100nm-thick films over large areas. Indeed, semiconductor inks generally have low viscosity which limits the range of adequate printing techniques. Furthermore, substrates and electrodes used have surface energy that is significantly different from those of organic semiconductor inks, which can lead to wetting issues. Vertical segregation and other rheological effects also make it difficult to control the nano-scale phase-separated morphology which is necessary for the good operation of bulk heterojunctions. In addition, stability of the inks formulation is another challenge.

Furthermore, a "solvent way" process may be used in preparing photovoltaic cells comprising multi-layers of semiconducting polymers. However, it is very difficult, in such manufacturing process, to control the homogeneity of the deposed layer and to use it for the fabrication of large area photovoltaic cells. The potential toxicity of such a manufacturing process due to the use of important quantities of organic solvents is not negligible as well.

### Aims of the invention

The present invention aims to provide an organic photovoltaic cell which does not have the drawbacks of the prior art.

The invention aims to provide an organic photovoltaic cell which is an alternative to the organic photovoltaic cells of the prior art.

The invention aims to provide an organic photovoltaic cell having a high environmental stability.

The invention provides an organic photovoltaic cell with substantially improved lifetime under illumination in ambient air.

The invention provides an organic photovoltaic cell having not only light absorption but also near infrared region absorption.

The present invention aims to provide an organic photovoltaic cell able to buildup a voltage between two electrodes even though only a very small surface area of the photoactive layers is being excited by light.

The present invention aims to provide a process to produce an organic photovoltaic cell which does not have the drawbacks of the prior art.

The present invention aims to provide a process to produce an organic photovoltaic cell which enables to control the structure and the thickness of the n-type and a p-type materials.

### Summary of the invention

The present invention discloses an organic photovoltaic cell comprising an anode, a cathode and a support, said photovoltaic cell comprising a p-type material and an n-type material, said p-type material being a layer of highly crystalline polyaniline deposited on at least one surface of said support, said n-type material being a layer of low crystalline polyaniline or amorphous polyaniline deposited on said layer of highly crystalline polyaniline.

According to particular embodiments, the organic photovoltaic cell may comprise one, or a suitable combination of one or several, of the following characteristics:
- the layer of highly crystalline polyaniline has a thickness comprised between 10 and 30 nm,
- the anode is a layer of conductive anodic material deposited between the support and the highly crystalline polyaniline,
- the anode is the layer of highly crystalline polyaniline,
- the support is transparent or semi-transparent to visible light,
- the cathode is made of metal and forms a grid which partially covers the layer of low crystalline polyaniline or amorphous polyaniline,

The present invention further discloses a photovoltaic module comprising a plurality of electrically connected organic photovoltaic cells according to the invention.

The present invention discloses also a photovoltaic window panel comprising a frame and the organic photovoltaic cell according to the invention, wherein the support is transparent to visible light and the cathode covers the border portion of the layer of the low crystalline polyaniline or amorphous polyaniline and is embedded in the frame.

The present invention further discloses a process to produce the organic photovoltaic cell according to the invention, said process comprising the steps of:
a) Providing a support,
b) Depositing on said support at least one layer of highly crystalline polyaniline,
c) Washing and drying said support comprising highly crystalline polyaniline,
d) Depositing on said at least one layer of highly crystalline polyaniline a layer of semi-crystalline or amorphous polyaniline,
e) Depositing on said layer of semi-crystalline or amorphous polyaniline a metal to form a cathode, said cathode covering all, or a portion, of said layer of semi-crystalline or amorphous polyaniline.

According to particular embodiments, the process to produce the organic photovoltaic cell according to the invention may comprise one, or a suitable combination of one or several, of the following characteristics:
- the process further comprises a step of depositing on the support an anodic material layer before depositing the at least one layer of highly crystalline polyaniline,
- the deposition of the layer of highly crystalline polyaniline is performed, between -35°C and 20°C, in a aqueous reaction medium comprising an acid, at least one salt, 0.01 to 0.04 mol/1 of aniline, 0.01 to 0.04 mol/1 of an oxidant, the concentration of the acid and the concentration of the at least one salt being so that the ionic force of the reaction medium being comprised between 5 to 10 mol/1,
- the deposition of the layer of semi-crystalline or amorphous polyaniline is performed, during between 2 to 30 minutes, at a temperature of between 20 and 80°C, in a aqueous reaction medium comprising an acid, 0.01 to 0.04 mol/1 of aniline, 0.01 to 0.04 mol/1 of an oxidant, the ionic force of the reaction medium being 0.1 to 4.5 mol/l,
- the acid is selected in the group consisting of formic acid or acetic acid and HCl,
- the at least one salt is selected in the group consisting of NaCI, LiCI, KCI, CaCI₂ and a combination thereof,
- the deposition of the layer of highly crystalline polyaniline (4) is performed on two opposite surfaces (21 and 22) of the support.

### Brief description of the drawings

Figure 1 is a side view representation of the photovoltaic cell according to a first embodiment of the present invention.

Figure 2 is a side view representation of the photovoltaic cell according to a second embodiment of the present invention.

Figure 3 is a side view representation of the photovoltaic cell according to a third embodiment of the present invention.

Figure 4 is a front view representation of the photovoltaic cell according to a fourth embodiment of the present invention.

Figure 5 is a front view representation of the photovoltaic cell according to a fifth embodiment of the present invention.

Figure 6 is a front view representation of the photovoltaic cell according to a sixth embodiment of the present invention.

Figure 7 is an AFM image of the surface area (50µmx50µm) of a highly crystalline polyaniline layer (A) and of a low crystalline one (B). The thickness of both layers is in the range of 20 to 30 nm.

Figure 8 represents the electron diffraction from a highly crystalline polyaniline layer monitoring a high orientation of polyaniline chains: the reflexes corresponding to distance assured by π-π inter-chain interactions are situated in the fibril direction. The layer thickness is 20 nm.

Figure 9 represents the electron absorption spectra of photovoltaic cells according to the invention having a thickness of the highly crystalline polyaniline layer of 10 nm. The VOC of the cells is 0.5V.

Figure 10 represents the electron absorption spectra of photovoltaic cells according to the invention having a thickness of the highly crystalline polyaniline layer of 20 nm. The VOC of the cells is 0.3V.

Figure 11 represents the enhancement of the photovoltaic effect of the photovoltaic cell according to the invention after deposition of a small water drop in the middle of the n-type polyaniline layer.

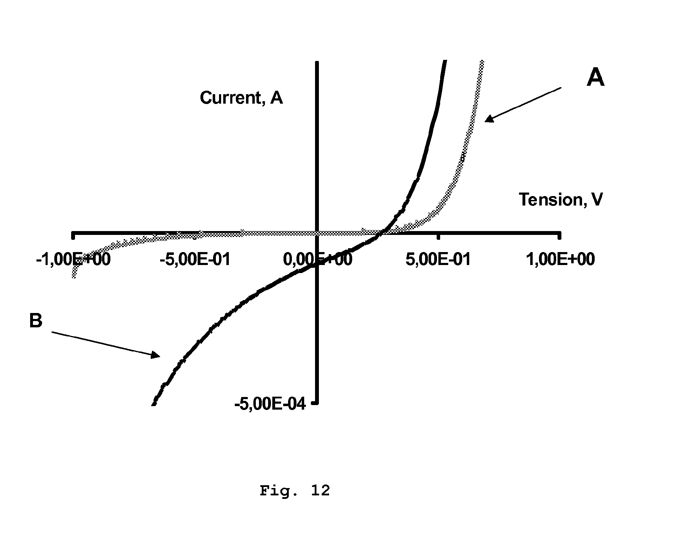

Figure 12 represents the current-voltage dependence of the organic photovoltaic cell according to the invention in dark (A) or under illumination (B). The cell used was obtained on a glass support of 1mm thickness. The current-voltage characteristics were detected when the illumination source was placed at the support side of the cell.

### Detailed description of the invention

The present invention relates to an organic photovoltaic cell 1, or organic photovoltaic diode, comprising a p-type material and an n-type material having the same chemical structure and which exhibit photoinduced charge transfer, photoinduced spectral changes (optical memory) and/or lead to the separation of charges with a photovoltaic effect at the interface between both layers.

The organic photovoltaic cell 1 comprises the same conjugated polymer as electron donor and as electron acceptor in the p-n junction structure, the p-type material being a high crystalline form of the polymer and said n-type material being a low crystalline or amorphous form of the polymer.

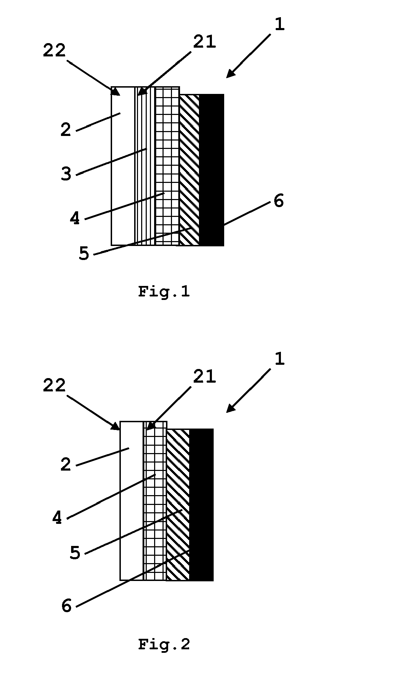

Preferably the organic photovoltaic cell 1 comprises at least one layer of highly crystalline p-type polyaniline 4 deposited on at least one surface (21 or 22) of any suitable support 2, possibly previously covered with any suitable anodic material 3, and comprises at least one layer of low-crystalline or amorphous n-type polyaniline 5 deposited on the highly crystalline polyaniline layer 4 (Figures 1 and 2).

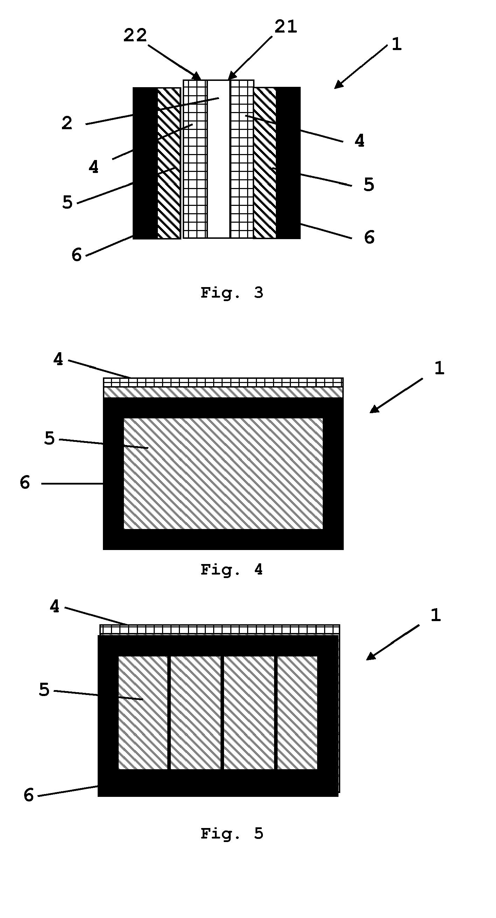

In another preferred embodiment (Fig.3), the organic photovoltaic cell 1 comprises one layer of highly crystalline p-type polyaniline 4 deposited on two opposite surfaces 21 and 22 of any suitable support 2, possibly previously covered with any suitable anodic material 3, and at least one layer of low-crystalline or amorphous polyaniline n-type 5 deposited on the two layers of highly crystalline polyaniline 4.

"Highly crystalline" polyaniline should be understood as polyaniline having a crystallinity level higher than about 60%, and "low-crystalline" polyaniline should be understood as polyaniline having a crystallinity level lower than about 40%.

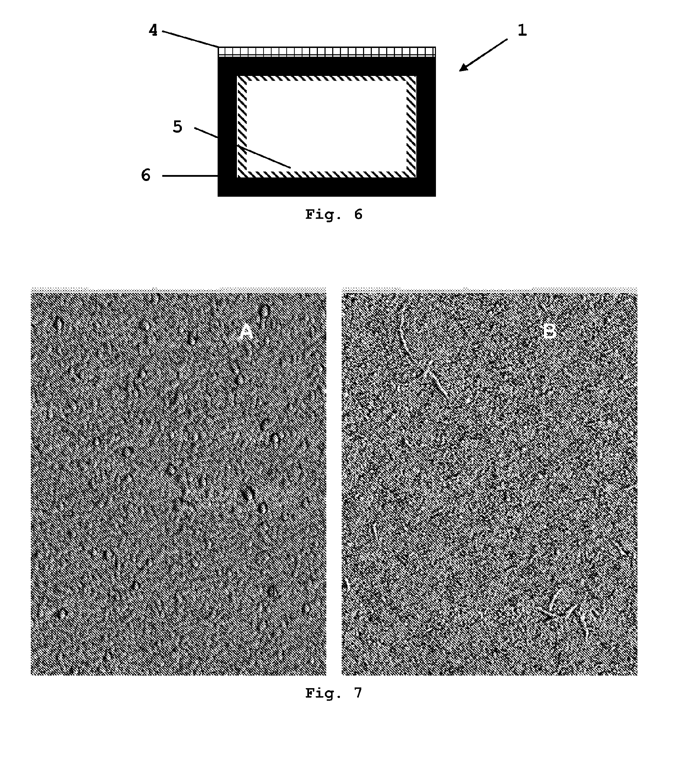

A highly ordered polyaniline layer shows fibril morphology (Fig. 6) and electron diffraction typical for highly ordered and oriented (fibril like) polymers (Fig. 7). Low crystalline thin polyaniline layers do not show any orientation and amorphous polyaniline is characterized by a granular and smooth surface.

Preferably, the overall thickness of the n-type and the p-type polyaniline is comprised between 20 to 50nm. The thickness of the layer of highly crystalline polyaniline 4 (i.e. the p-type layer) is comprised between 10 and 30nm.

The support 2 of the organic photovoltaic cell 1 is any suitable support 2, or substrate, made of any suitable material. It may be for example glass, metal, ceramic, or polymer, having any suitable thickness, preferably about 20 to 30 µm microns to about 10 millimetres.

The support 2 may be non-transparent, semi-transparent or transparent to visible light. Preferably, the non-transparent or semi-transparent support may be formed from a polymer mixture or polymer composites. More preferably, the support 2 is transparent and may be made of glass, quartz, suitable polymers or copolymers, such as polyethylene therephtalates, polyimides, polyethylene naphtalate, polymeric hydrocarbons, cellulostic polymers, polycarbonate, polyamides, polyethers, polyether ketones, and derivates thereof.

In the context of the present invention, "semi-transparent" means that at least 50% of the visible light could pass, and "transparent means" that at least 70% of the visible light could pass.

The anode of the photovoltaic cell according to the invention, collecting the hole charge carried from the photoactive layers 4 and 5, may be either any suitable conducting material layer 3 or may be the layer of highly crystalline polyaniline 4 deposited on one of the surfaces 21 or 22 (Fig. 1 or Fig.2), or deposited on both opposite surfaces 21 and 22 (Fig. 3) of the non-conductive support 2.

The anode can cover the entire surface, or only a part of the surfaces 21 or 22 of the support 2.

In the embodiment in which the anode is a conducting material 3 covering the support 2, said anode may be transparent or non-transparent to visible light. Examples of materials from which the transparent anode can be made are conductive metal-metal oxides or sulfide materials such indium-tin oxide (ITO). Other materials such as gold or copper can also be used. In this embodiment, the thickness of anode is preferably comprised between 40 and 100 nm.

In the embodiment in which the anode is formed by the highly crystalline polyaniline layer 4, the thickness of the highly crystalline polyaniline layer 4 is comprised between 20 to 30nm for an organic cell having a transmission of around 70 % of visible light.

The cathode 6, which collects the electron charge carried from the photoactive material, is typically made of any suitable metal, as for example aluminium (Al). The cathode covers all, or only on some areas, of the surface of the n-type material, by any suitable method, by vapour deposition for example.

In one embodiment, the cathode 6 covers the border of the n-type layer (Fig.4).

In another embodiment, the cathode 6 is a grid or a wire network which covers some areas of the surface of the n-type material.

As the cathode 6 does not need to be transparent, conducting materials such as silver in various forms, e.g. silver paste comprising silver particles dispersed in a solvent, can be used to form the cathode 6. The use of silver paste enables thus the deposition of the cathode 6 by printing technologies.

For transparent applications (Fig. 5), the border of a transparent support 2 may be covered by the p-type material and the n-type material, which are covered by the cathode 6.

The organic photovoltaic cell 1 according to the invention has the advantage to be directly exposed to the light due to the high environmental stability of photoactive layers 4 and 5. However, the organic photovoltaic cell 1 may further comprise a protective layer covering the n-type layer and/or the cathode 6 and applied by any suitable method. Preferably it is a transparent protective layer made of, for example, polystyrene, polyacrylates and their copolymers, having a thickness comprised between 1 to 20 microns.

The organic photovoltaic cell 1 according to the invention has also the advantage of being a cell where the light hits the cathode side first, meaning that the light does not need to cross the support (e.g. glass support) first prior to access to the photoactive organic layers, therefore optimizing the light absorption of the photovoltaic cell 1.

The organic photovoltaic cell 1 may further comprise any suitable means, such as wires, to transfer to any suitable device, to store or use the electricity thus produces.

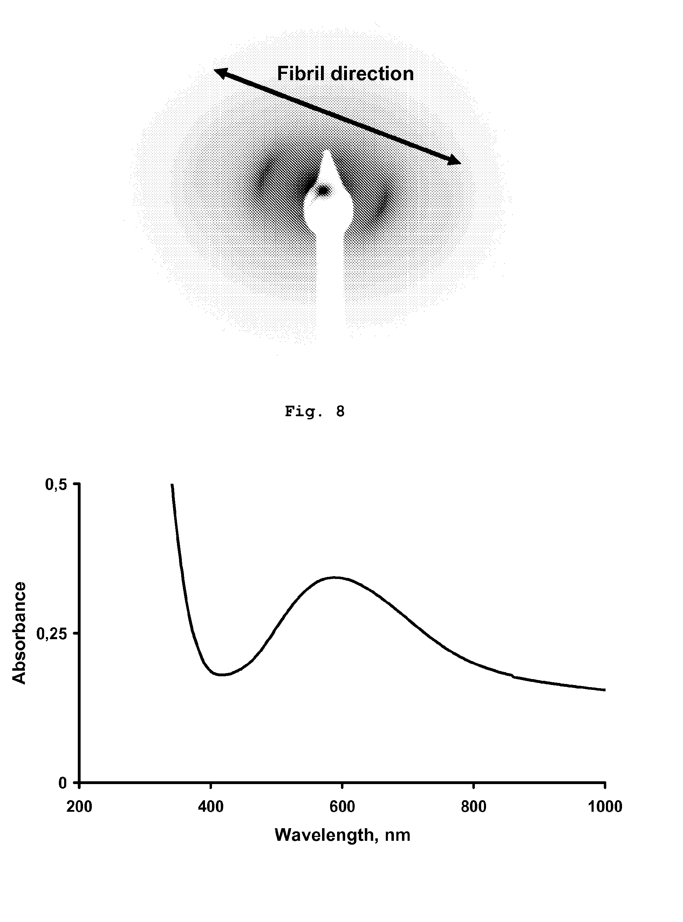

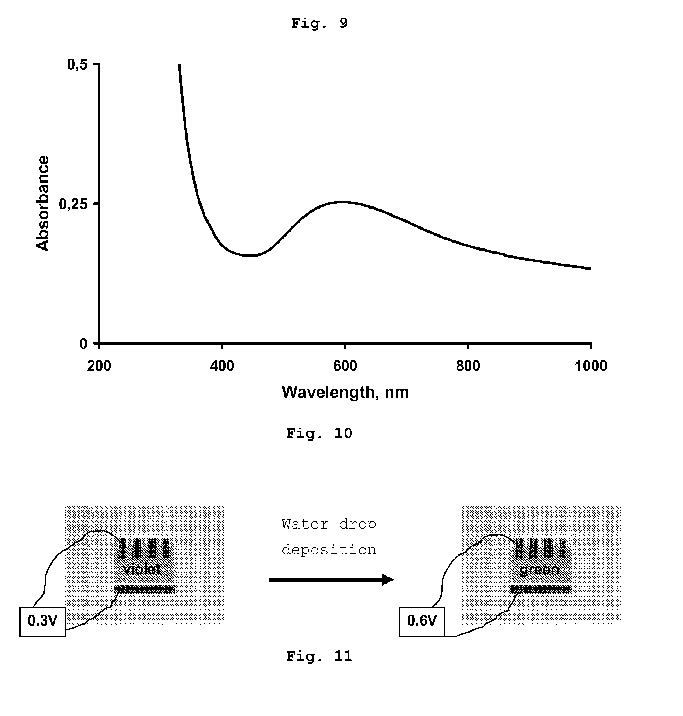

From optical spectra of the photovoltaic cell according to the invention (Figures 8 and 9), it appears that a decrease of the thickness of the highly crystalline polyaniline layer leads to an increase of Voc of the photovoltaic cell.

As shown in figure 10, the organic photovoltaic cell 1 according to the invention surprisingly presents an improved efficiency when the photovoltaic cell is put in a humid atmosphere or if the photovoltaic cell is partially or completely covered by a thick water layer, such as when the photovoltaic cell is partially or completely immersed into water. Indeed, a strong increase of the open circuit voltage (V_{0C}), from 0.3 to 0.6V, is observed when a drop of water is deposed on the surface of the n-type polyaniline layer 5. This phenomenon is related to improved stability of excitons by the presence of highly polarized water molecules.

Current-voltage measures (Fig. 11) were performed in ambient air. The support 2 of the photovoltaic cell was made of glass of 1mm thickness. The current-voltage characteristics were detected when the illumination source was placed at the support side of the photovoltaic cell. It appears that the characteristics of the photovoltaic cell are maintained both at ambient conditions and after thermal ageing at 60°C for at least 6 months.

A plurality of organic photovoltaic cells 1 according to the invention may be electrically connected to form a photovoltaic module.

The organic photovoltaic cell 1 may be part of a photovoltaic device as for example a roofing, package labelling, battery charger, sensors, windows, window shades and blinds, exterior wall panels, clothes or bag integrated devices.

Preferably, the photovoltaic cell 1 is a window panel. More preferably, the window panel comprises a support transparent to visible light and a frame, the support being all covered, or partially covered, possibly by an anodic material 3, by the layer of highly crystalline polyaniline 4, the layer of low crystalline polyaniline or amorphous polyaniline 5, the cathode 6 covering the border of the layer of said low crystalline polyaniline or amorphous polyaniline 5, and the cathode 6 preferably being embedded in the frame of the window panel.

The organic photovoltaic cell according to the invention is produced by consecutive deposition of polyaniline layers with different supramolecular structure on the support 2, possibly pre-covered by an anode layer 3, and immersion in a aqueous reaction medium where polymerization takes place, said reaction medium comprising an acid, for example formic acid, acetic acid or HCI, aniline in concentration of between 0.01 to 0.04 mol/1, an oxidant in a concentration of between 0.01 to 0.04 mol/1, at least one salt, or combination of salts, such as NaCI, LiCI, KCI, or CaCI₂. The concentration of acid and of the at least one salt is selected so that the ionic force of the reaction medium is between 5 and 10 mol/1. The reaction is performed at a temperature of -35° to 20°C, to produce highly crystalline polyaniline having a level of crystallinity higher that 60%.

When the polymerization is performed in the presence of an acid having a pKa of between 3 and 5, such as formic or acetic acid, the high ionic force of the reaction medium is obtained by the addition of a salt, or a mixture of salts, at a concentration comprise between 0.5 mol/1 and their saturation concentration at a given temperature, while when the polymerization is performed in the presence of a strong acid such as HCI, the high ionic force is reached by use of a concentration of 5 to 7 mol/1 of said strong acid.

The oxidant may be any suitable oxidant. Preferably, it is permanganate, chromate, or peroxide based oxidant. More preferably, it is ammonium persulfate.

In the embodiment wherein the photovoltaic cell 1 comprises one layer of highly crystalline polyaniline 4 deposited only on one of the two opposite surfaces 21 or 22, the opposite surface, not intended to be covered by polyaniline, is protected using any suitable method during highly crystalline polyaniline deposition and washed just after its deposition by water.

After the first polyaniline layer 4 has been adsorbed on support 2, the second polyaniline layer 5 is then attached to the first one by covalent bonds. The polyaniline supramolecular structure (amorphous, semi-crystalline or highly-crystalline) and the thickness of the photoactive layer are controlled by the polymerization conditions.

The increase of the ionic force of the aqueous reaction medium and the decrease of the polymerization temperature down to -35°C favour the formation of highly crystalline polyaniline. These conditions promote chains organization via water molecules intercalation between the polyaniline chains. Therefore, the first polyaniline layer formed is a highly crystalline polyaniline, while the second polyaniline layer formed can be a semi-crystalline or amorphous polyaniline layer. The polyaniline thin layers are then dried at ambient humidity and pressure in the range of temperature of 20°C to 80°C.

As an example, a glass support 2, covered by ITO as anodic material 3, is immersed in a aqueous formic acid solution at 5mol/l, comprising 3 mol/1 of LiCl, 0.01 mol/1 of aniline, 0.01 mol/1 of (NH₄)₂S₂O₈ as oxidant at a temperature of -35°C.

The reaction medium changes from non-colored to violet, blue and finally green. The polymerisation reaction is stopped when the reaction medium passes to an intense violet colour or to a green colour.

The highly crystalline polyaniline thin film thus obtained is characterized by diffraction of electrons performed with Transmission Electron Microscope Philips-CM200, the degree of crystallinity being calculated from the diffraction curves corrected for the background and the Lorentz factor (L. E. Alexander, " X-Ray Diffraction Methods in Polymer Science", Robert E. Krieger, Huntington, NY 1979, pp. 210- 211). Furthermore, it is also characterized by UV-Vis-NIR electron absorption spectra obtained with Perkin Elmer Lambda 750 spectrophotometer and by its thickness determined by using atomic force microscopy (AFM) in tapping mode using a Digital Instruments MultiMode instrument coupled to a NanoScope IV controller.

The highly crystalline polyaniline thin film obtained has a crystallinity level higher than about 60%. It has a λₘₐₓ in transmission electron absorption spectra of between 570 to 620nm, and a thickness of between 5 to 100nm. Its absorption coefficient, measured at λ = 590nm, is around 1.6.10⁵ cm⁻¹.

The support, covered with high crystalline polyaniline, is then washed by immersion for 10 to 20 minutes in a formic acid aqueous solution of 5 mol/1 and then dried at atmospheric, or reduced pressure, up to 80°C, preferably between 60 to 80°C, during 30 to 60 minutes.

The support, comprising high crystalline polyaniline, washed and dried, is then immersed, during 2 to 30 minutes, at a temperature of between 80 or 20°C respectively, in a aqueous acid solution comprising an acid having a pKa comprised between 3 and 5, such as formic or acetic acid, or a strong acid, such as HCI, and possibly at least one salt, so that the reaction medium has an ionic force from 0.1 to 4.5 mol/1. The reaction medium further comprises 0.01 to 0.04 mol/1 of aniline and 0.01 to 0.04 mol/1 of an oxidant.

The oxidant used to deposit the semi-crystalline or amorphous polyaniline 5 may be any suitable oxidant. Preferably, it is permanganate, chromate, or peroxide based oxidant. More preferably, it is ammonium persulfate.

As an example, the glass support, covered by ITO as anodic material, and comprising the highly crystalline polyaniline is immersed in a aqueous 5 molar formic acid solution, having an ionic force of 0.1 mol/1, comprising 0.01 mol/1 of aniline, 0.01 mol/1 of (NH₄)₂S₂O₈ as oxidant at a temperature of 60°C.

Finally, a cathode, for example made of Aluminium, is then deposited onto the polyaniline layers, for example by vacuum deposition.

In Optical tests highly crystalline and low crystalline polyaniline thin films show an unprecedented phenomenon of optical memory at ambient temperature after a few seconds of laser irradiation.

Furthermore, both highly crystalline and low crystalline polyaniline thin films show a capacity to propagate a process of reduction at macroscopic level while normally such reaction is limited at the molecular level.

## Claims

1. Organic photovoltaic cell (1) comprising an anode, a cathode (5), and a support (2), said photovoltaic cell (1) comprising a p-type material and an n-type material, said p-type material being a layer of highly crystalline polyaniline (4) deposited on at least one surface (21 or 21) of said support (2), said n-type material being a layer of low crystalline polyaniline or amorphous polyaniline (5) deposited on said layer of highly crystalline polyaniline (4).

2. Organic photovoltaic cell (1) according to claim 1, wherein the layer of highly crystalline polyaniline (4) has a thickness comprised between 10 and 30 nm.

3. Organic photovoltaic cell (1) according to claim 1 or 2, wherein the anode is a layer of conductive anodic material (3) deposited between the support (2) and the highly crystalline polyaniline (4).

4. Organic photovoltaic cell (1) according to claims 1 to 3, wherein the anode is the layer of highly crystalline polyaniline (4).

5. Organic photovoltaic cell (1) according to any of the preceding claims, wherein the support (2) is transparent or semi-transparent to visible light.

6. Organic photovoltaic cell (1) according to any of the preceding claims, wherein the cathode (6) is made of metal and forms a grid which partially covers the layer of low crystalline polyaniline or amorphous polyaniline (5).

7. Photovoltaic module comprising a plurality of electrically connected organic photovoltaic cells according to claims 1 to 7.

8. A photovoltaic window panel comprising a frame and the organic photovoltaic cell (1) according to claims 1 to 7, wherein the support (2) is transparent to visible light and the cathode (6) covers the border portion of the layer of the low crystalline polyaniline or amorphous polyaniline (5) and is embedded in said frame.

9. Process to produce the organic photovoltaic cell according to claims 1 to 7, comprising the steps of:
a) Providing a support (2),
b) Depositing on said support (2) at least one layer of highly crystalline polyaniline (4),
c) Washing and drying said support (2) comprising highly crystalline polyaniline (4),
d) Depositing on said at least one layer of highly crystalline polyaniline (4) a layer of semi-crystalline or amorphous polyaniline (5),
e) Depositing on said layer of semi-crystalline or amorphous polyaniline (5) a metal to form a cathode (6), said cathode (6) covering all, or a portion, of said layer of semi-crystalline or amorphous polyaniline (5).

10. Process according to claim 9, further comprising a step of depositing on the support (2) an anodic material layer (3) before depositing the at least one layer of highly crystalline polyaniline (4).

11. Process according to claim 9 or 10, wherein the deposition of the layer of highly crystalline polyaniline (4) is performed, between -35°C and 20°C, in a aqueous reaction medium comprising an acid, at least one salt, 0.01 to 0.04 mol/1 of aniline, 0.01 to 0.04 mol/1 of an oxidant, the concentration of the acid and the concentration of the at least one salt being so that the ionic force of the reaction medium being comprised between 5 to 10 mol/1.

12. Process according any of the claims 9 to 11, wherein the deposition of the layer of semi-crystalline or amorphous polyaniline (5) is performed, during between 2 to 30 minutes, at a temperature of between 20 and 80°C, in a aqueous reaction medium comprising an acid, 0.01 to 0.04 mol/1 of aniline, 0.01 to 0.04 mol/1 of an oxidant, the ionic force of the reaction medium being 0.1 to 4.5 mol/1.

13. Process according to any of the claims 9 to 12, wherein the acid is selected in the group consisting of formic acid or acetic acid and HCI.

14. Process according to any of the claims 11 to 13, wherein the at least one salt is selected in the group consisting of NaCI, LiCI, KCI, CaCI₂ and a combination thereof.

15. Process according to any of the claims 9 to 14, wherein the deposition of the layer of highly crystalline polyaniline (4) is performed on two opposite surfaces (21 and 22) of the support (2).
